(19) Europäisches Patentamt
European Patent Office
Office européen des brevets

(11) **EP 2 747 536 A1**

(12) **EUROPEAN PATENT APPLICATION**
published in accordance with Art. 153(4) EPC

(43) Date of publication:
**25.06.2014 Bulletin 2014/26**

(51) Int Cl.:
**H05K 7/20** (2006.01)

(21) Application number: **13801456.8**

(22) Date of filing: **24.04.2013**

(86) International application number:
**PCT/CN2013/074619**

(87) International publication number:
**WO 2014/063476 (01.05.2014 Gazette 2014/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.10.2012 CN 201210410113**

(71) Applicant: **Huawei Technologies Co., Ltd.**
**Shenzhen, Guangdong 518129 (CN)**

(72) Inventors:
• **XU, Yan**
  **Shenzhen, Guangdong 518129 (CN)**
• **TU, Yunhua**
  **Shenzhen, Guangdong 518129 (CN)**

(74) Representative: **Haley, Stephen**
**Gill Jennings & Every LLP**
**The Broadgate Tower**
**20 Primrose Street**
**London EC2A 2ES (GB)**

(54) **HEAT-CONDUCTING PAD, METHOD FOR MANUFACTURING HEAT-CONDUCTING PAD, RADIATING APPARATUS AND ELECTRONIC DEVICE**

(57) Embodiments of the present invention disclose a thermal pad, a method for fabricating a thermal pad, a heat dissipating apparatus, and an electronic device. The thermal pad includes: a thermally conductive sheet-like substrate, where the sheet-like substrate has a compressible porous mesh structure in a thickness direction; and a thermally conductive coating, where the coating is formed of a flexible organic compound, and the organic compound fills inside the sheet-like substrate or is coated on a surface of the sheet-like substrate, or the organic compound both fills inside the sheet-like substrate and is coated on the surface of the sheet-like substrate. In the thermal pad, the method for fabricating a thermal pad, the heat dissipating apparatus, and the electronic device provided in the embodiments of the present invention, a thermally conductive flexible organic compound fills inside or is coated on a thermally conductive sheet-like substrate having a compressible porous mesh structure in the thickness direction, so that the formed thermal pad has high thermal conductivity as well as shigh compressibility, and therefore can improve heat dissipation performance of the electronic device.

FIG. 1

## Description

### TECHNICAL FIELD

The present invention relates to the field of electronic devices, and in particular, to a thermal pad, a method for fabricating a thermal pad, a heat dissipating apparatus, and an electronic device in the field of electronic devices.

### BACKGROUND

Heat generated by chips that work in electronic devices generally needs to be dissipated to the outside by using heat dissipaters. From a microscopic perspective, much roughness exists on a contact interface between the chip and the heat dissipater, and the contact interface between a chip and a heat dissipater needs to be filled with thermal interface materials to reduce thermal contact resistance. The thermal interface materials generally include thermally conductive silicone, thermal pads, thermal gels, phase-change thermally conductive materials, thermally conductive double-sided tapes, and the like. In different application scenarios, different types of thermal interface materials of different thermal conductivities may be used.

Thermal conduction is a physical process related to unordered random motion of microscopic particles such as atoms, molecules and free electrons. Because polymer materials lack a homogeneous and dense ordered crystal structure or a charge carrier, heat conductivity thereof is poor. Currently, two major ways are available for improving the heat conductivity of polymer materials: firstly, to prepare a highly conductive structural polymer material, such as a polyacetylene or a polyaniline or a polypyrrole having a conjugated structure, or improve polymer crystallinity and achieve the purpose of thermal conduction by using a phonon thermal conduction mechanism; and then to prepare a filler-type polymer composite by adding highly conductive fillers into a substrate. In practical industrial application, thermally conductive polymer materials are typically prepared by adding thermally conductive fillers into an organic substrate.

Both the thermal pads and the thermal gels are thermally conductive composite materials formed as a result of polymerization under certain conditions after thermally conductive fillers are added into organic resin to evenly distribute the thermally conductive fillers in the polymeric organic resin. Sheet-like thermally conductive composite materials are generally called thermal pads, and gel-like thermally conductive composite materials are generally called thermal gels. Because the thermal pads and the thermal gels are soft and flexible, and can be compressed to a certain percentage of their initial thickness under a specific pressure, which can compensate for assembly tolerance and fill assembly gaps between a heat emitting component and a heat dissipating component, so as to transmit heat from the heat emitting component to the heat dissipating component.

For filler-type polymeric composite materials such as thermal pads and thermal gels, the improvement of their thermal conductivity primarily depends on the thermal conductivity of the fillers, and distribution of the fillers in the substrate, and interaction between the fillers and the substrate.

When the content of the filler particles is relatively small, the particles are distributed in the substrate evenly and separately, and opportunities for contact between the particles are relatively small. Therefore, the particles are enclosed by the substrate to form an "island" structure, in which the fillers are a dispersed phase and the polymer materials are a continuous phase. Even the fillers of a high thermal conductivity make few contributions to the improvement of the thermal conductivity of the composite materials. The thermal conductivity of the polymeric composite materials can be improved by adding a greater number of thermally conductive fillers, distributing the thermally conductive fillers properly, and implementing contact between more particles of the thermally conductive fillers to form a heat conduction path.

With the trend of the high density and miniaturization of electronic devices, chips and circuit boards have higher power densities, and it is more often that multiple chips share the same heat dissipater for dissipating heat. Because different chips have different heights and height tolerances, certain gaps exist between the chips and a heat dissipater when the same heat dissipater is assemblied. Generally a soft and flexible thermal interface material is required to fill the gaps, absorb the tolerances, and achieve the heat conduction function properly.

However, in a scenario in which thermally conductive fillers are added and blended with an organic resin substrate to form a polymeric composite material, a higher thermal conductivity generally contradicts a higher applicability. In practical application, a key performance of a thermal pad is compressibility. A higher thermal conductivity means a higher content of thermally conductive fillers, and lowers compressibility of the thermal pad. Lower compressibility of the thermal pad leads to higher compressive stress of the thermal pad when the same tolerance is compensated for, which possibly impairs the circuit board and its components. In practical application, a key performance of a thermal gel is applying ability. A higher thermal conductivity means a higher content of thermally conductive fillers, and leads to excessively viscosity of the thermal gel. Excessively viscosity of the thermal gel makes it hard to apply the thermal gel through a gel dispensing process, and makes mass industrial processing impracticable.

Therefore, with the constant rise of the power density of heat emitting components in an electronic device, the power density of a board rises constantly, thereby imposing higher requirements on the heat conductivity of thermal interface materials. The thermal pads and the thermal gels manufactured in the prior art no longer meet heat dissipation requirements of some high-performance electronic devices, and excessive temperature rise between heat emitting components and a heat dissipater has become a bottleneck in heat dissipation. In this case, on the premise of ensuring high compressibility, it is necessary to continue improving the thermal conductivity of thermal interface materials that are soft and flexible.

## SUMMARY

Embodiments of the present invention provide a thermal pad, a method for fabricating a thermal pad, a heat dissipating apparatus, and an electronic device so that the thermal pad has high thermal conductivity as well as high compressibility.

In a first aspect, an embodiment of the present invention provides a thermal pad. The thermal pad includes: a thermally conductive sheet-like substrate, where the sheet-like substrate has a compressible porous mesh structure in a thickness direction; and a thermally conductive coating, where the coating is formed of a flexible organic compound, and the organic compound fills inside the sheet-like substrate or is coated on a surface of the sheet-like substrate, or the organic compound both fills inside the sheet-like substrate and is coated on the surface of the sheet-like substrate.

In a first possible implementation manner of the first aspect, a thermal conductivity of the thermal pad is greater than or equal to 3 W/mK; or a thermal conductivity of the thermal pad falls within a range from 3 W/mK to 5 W/mK; or a thermal conductivity of the thermal pad falls within a range from 5 W/mK to 15 W/mK; or a thermal conductivity of the thermal pad falls within a range from 15 W/mK to 30 W/mK.

In a second possible implementation manner of the first aspect, a Shore hardness of the thermal pad is less than or equal to Shore A 60; or a Shore hardness of the thermal pad is less than or equal to Shore OO 60.

In a third possible implementation manner of the first aspect, a compressive stress of the thermal pad under a 50% compression rate is less than or equal to 100 psi; or a compressive stress of the thermal pad under a 50% compression rate is less than or equal to 150 psi; or a compressive stress of the thermal pad under a 50% compression rate is less than or equal to 250 psi.

With reference to the first aspect or any one of possible implementation manners ranging from the first to the third possible implementation manners of the first aspect, in a fourth possible implementation manner of the first aspect, a thermal conductivity of the sheet-like substrate is greater than or equal to 2 W/mK; or a thermal conductivity of the sheet-like substrate falls within a range from 5 W/mK to 30 W/mK.

With reference to the first aspect or any one of possible implementation manners ranging from the first to the third possible implementation manners of the first aspect, in a fifth possible implementation manner of the first aspect, a porosity of the sheet-like substrate is greater than or equal to 50%; or a porosity of the sheet-like substrate falls within a range from 80.0% to 99.8%.

With reference to the first aspect or any one of possible implementation manners ranging from the first to the third possible implementation manners of the first aspect, in a sixth possible implementation manner of the first aspect, the porous mesh structure of the sheet-like substrate is made of a metal material or carbon material.

With reference to the sixth possible implementation manner of the first aspect, in a seventh possible implementation manner of the first aspect, the sheet-like substrate is an expandable graphite sheet, a foamed metal sheet, or a graphene foam sheet.

With reference to the first aspect or any one of possible implementation manners ranging from the first to the third possible implementation manners of the first aspect, in an eighth possible implementation manner of the first aspect, a thermal conductivity of the organic compound falls within a range from 0.5 W/mK to 6 W/mK; or a thermal conductivity of the organic compound falls within a range from 1 W/mK to 3 W/mK.

With reference to the first aspect or any one of possible implementation manners ranging from the first to the third possible implementation manners of the first aspect, in a ninth possible implementation manner of the first aspect, a Shore hardness of the coating is less than or equal to Shore OO 60; or a Shore hardness of the coating is less than or equal to Shore OO 30.

With reference to the first aspect or any one of possible implementation manners ranging from the first to the third possible implementation manners of the first aspect, in a tenth possible implementation manner of the first aspect, a thickness of the coating that is coated on the surface of the sheet-like substrate falls within a range from 1 $\mu$m to 0.5 mm.

With reference to the seventh possible implementation manner of the first aspect, in an eleventh possible implementation manner of the first aspect, the sheet-like substrate is an expandable graphite sheet, a density of the expandable graphite sheet falls within a range from 0.1 g/cm$^3$ to 0.25 g/cm$^3$, a porosity of the sheet-like substrate falls within a range from 89.0% to 96.0%, and the thermal conductivity of the thermal pad falls within a range from 5 W/mK to 25 W/mK.

With reference to the seventh possible implementation manner of the first aspect, in a twelfth possible implementation manner of the first aspect, the sheet-like substrate is a foamed copper sheet, a porosity of the foamed copper sheet falls within a range from 90.0% to 98.0%, and a pore size of the foamed copper sheet falls within a range from 90 PPI to 120 PPI; or the sheet-like substrate is a graphene foam sheet, a porosity of the graphene foam sheet falls within a range from 80.0% to 99.8%, and a pore size of the graphene foam sheet falls within a range from 90 PPI to 120 PPI.

In a second aspect, an embodiment of the present invention provides a method for fabricating a thermal pad. The method includes: providing a thermally conductive sheet-like substrate, where the sheet-like substrate has a compressible porous mesh structure in a thickness direction; and providing a thermally conductive and flexible organic compound, and using the organic compound to fill inside the sheet-like substrate or coat on a surface of the sheet-like substrate, or using the organic compound to both fill inside the sheet-like substrate and coat on the surface of the sheet-like substrate to form the thermal pad.

In a first possible implementation manner of the second aspect, the using the organic compound to fill inside the sheet-like substrate or coat on a surface of the sheet-like substrate, or the using the organic compound to both fill inside the sheet-like substrate and coat on the surface of the sheet-like substrate to form the thermal pad includes: winding or overlaying the sheet-like substrate to form a multilayer sheet-like substrate with a multilayer structure; using the organic compound to fill inside the sheet-like substrate or coat on the surface of the sheet-like substrate, or using the organic compound to both fill inside the sheet-like substrate and coat on the surface of the sheet-like substrate to form a first thermal pad blank; and cutting the first thermal pad blank along a heat conduction direction of the first thermal pad blank to form the thermal pad.

In a second possible implementation manner of the second aspect, the using the organic compound to fill inside the sheet-like substrate or coat on a surface of the sheet-like substrate, or the using the organic compound to both fill inside the sheet-like substrate and coat on the surface of the sheet-like substrate to form the thermal pad includes: using the organic compound to fill inside the sheet-like substrate or coat on the surface of the sheet-like substrate, or using the organic compound to both fill inside the sheet-like substrate and coat on the surface of the sheet-like substrate to form a second thermal pad blank; winding or overlaying the second thermal pad blank to form a third thermal pad blank with a multilayer structure; and cutting the third thermal pad blank along a heat conduction direction of the third thermal pad blank to form the thermal pad.

With reference to the second aspect or the first or second possible implementation manner of the second aspect, in a third possible implementation manner of the second aspect, a thermal conductivity of the sheet-like substrate is greater than or equal to 2 W/mK; or a thermal conductivity of the thermal pad falls within a range from 5 W/mK to 30 W/mK.

With reference to the second aspect or the first or second possible implementation manner of the second aspect, in a fourth possible implementation manner of the second aspect, a porosity of the sheet-like substrate is greater than or equal to 50%; or a porosity of the sheet-like substrate falls within a range from 80.0% to 99.8%.

With reference to the second aspect or the first or second possible implementation manner of the second aspect, in a fifth possible implementation manner of the second aspect, the porous mesh structure of the sheet-like substrate is made of a metal material or carbon material, or the sheet-like substrate is an expandable graphite sheet, a foamed metal sheet, or a graphene foam sheet.

With reference to the second aspect or the first or second possible implementation manner of the second aspect, in a sixth possible implementation manner of the second aspect, a thermal conductivity of the organic compound falls within a range from 0.5 W/mK to 6 W/mK; or a thermal conductivity of the organic compound falls within a range from 1 W/mK to 3 W/mK.

With reference to the second aspect or the first or second possible implementation manner of the second aspect, in a seventh possible implementation manner of the second aspect, a Shore hardness of the organic compound is less than or equal to Shore OO 60 after the organic compound is solidified; or a Shore hardness of the organic compound is less than or equal to Shore OO 30 after the organic compound is solidified.

In a third aspect, an embodiment of the present invention provides a heat dissipating apparatus. The heat dissipating apparatus includes: a heat dissipating component; and a thermal pad disposed between the heat dissipating component and a heat emitting component according to an embodiment of the present invention, or a thermal pad manufactured according to a method disclosed in an embodiment of the present invention.

The thermal pad includes: a thermally conductive sheet-like substrate, where the sheet-like substrate has a compressible porous mesh structure in a thickness direction; and a thermally conductive coating, where the coating is formed of a flexible organic compound, and the organic compound fills inside the sheet-like substrate or is coated on a surface of the sheet-like substrate, or the organic compound both fills inside the sheet-like substrate and is coated on the surface of the sheet-like substrate.

The method for fabricating a thermal pad includes: providing a thermally conductive sheet-like substrate, where the sheet-like substrate has a compressible porous mesh structure in a thickness direction; and providing a thermally conductive and flexible organic compound, and using the organic compound to fill inside the sheet-like substrate or coat on a surface of the sheet-like substrate, or using the organic compound to both fill inside the sheet-like substrate and coat on the surface of the sheet-like substrate to form the thermal pad.

In a fourth aspect, an embodiment of the present invention provides an electronic device. The electronic device includes: a heat emitting component; a heat dissipating component; and a thermal pad disposed between the heat emitting component and the heat dissipating component according to an embodiment of the present invention, or a thermal pad manufactured according to a method disclosed in an embodiment of the present invention.

The thermal pad includes: a thermally conductive sheet-like substrate, where the sheet-like substrate has a compressible porous mesh structure in a thickness direction; and a thermally conductive coating, where the coating is formed of a flexible organic compound, and the organic compound fills inside the sheet-like substrate or is coated on a surface of the sheet-like substrate, or the organic compound both fills inside the sheet-like substrate and is coated on the surface of the sheet-like substrate.

The method for fabricating a thermal pad includes: providing a thermally conductive sheet-like substrate, where the sheet-like substrate has a compressible porous mesh structure in a thickness direction; and providing a thermally conductive and flexible organic compound, and using the organic compound to fill inside the sheet-like substrate or coat on a surface of the sheet-like substrate, or using the organic compound to both fill inside the sheet-like substrate and coat on the surface of the sheet-like substrate to form the thermal pad.

Based on the foregoing technical solutions, in the thermal pad, the method for fabricating a thermal pad, the heat dissipating apparatus, and the electronic device provided in the embodiments of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

## BRIEF DESCRIPTION OF DRAWINGS

To illustrate the technical solutions in the embodiments of the present invention more clearly, the following briefly introduces the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.

FIG. 1 is a schematic cross-sectional diagram of a thermal pad according to an embodiment of the present invention;

FIG. 2 is a schematic flowchart of a method for fabricating a thermal pad according to an embodiment of the present invention;

FIG. 3 is another schematic flowchart of a method for fabricating a thermal pad according to an embodiment of the present invention;

FIG. 4 is another schematic flowchart of a method for fabricating a thermal pad according to an embodiment of the present invention;

FIG. 5 is a schematic structural diagram of a heat dissipating apparatus according to an embodiment of the present invention; and

FIG. 6 is a schematic structural diagram of an electronic device according to an embodiment of the present invention.

## DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

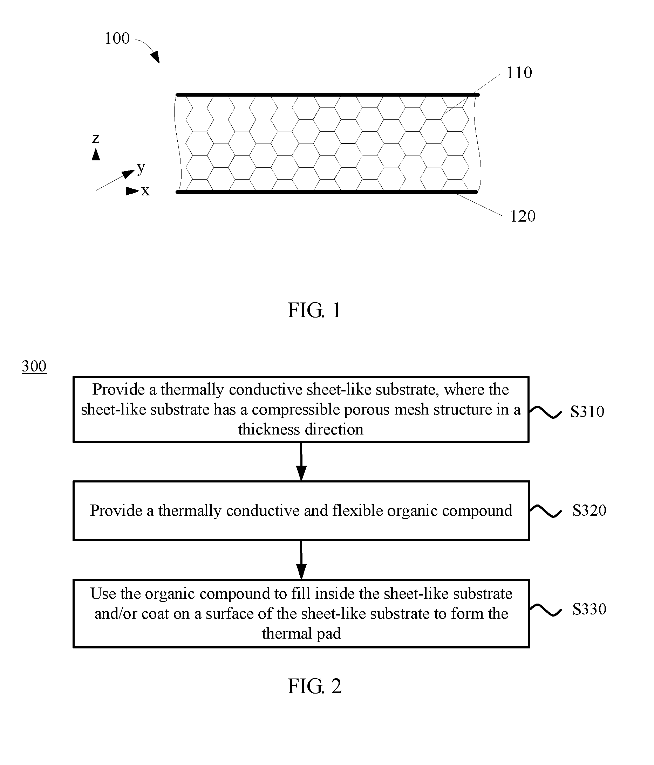

FIG. 1 is a cross-sectional schematic diagram of a thermal pad 100 according to an embodiment of the present invention. As shown in FIG. 1, the thermal pad 100 includes:

a thermally conductive sheet-like substrate 110, where the sheet-like substrate 110 has a compressible porous mesh structure in a thickness direction; and

a thermally conductive coating 120, where the coating 120 is formed of a flexible organic compound, where

the organic compound fills inside the sheet-like substrate 110 or is coated on a surface of the sheet-like substrate 110.

In the thermal pad provided in the embodiment of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

It should be understood that, in the embodiment of the present invention, the thickness direction is a direction perpendicular to a plane on which the sheet-like substrate is disposed. As shown in FIG. 1, the thickness direction of the sheet-like substrate 110 is the z direction. The compressibility of the sheet-like substrate in the embodiment of the present invention may, in an aspect, depend on the brittleness of the material of the sheet-like substrate because the sheet-like substrate tends to break off in the thickness direction so as to be compressed when the sheet-like substrate receives an external compressive force in the thickness direction, and, in another aspect, the compressibility may depend on the porous mesh structure of the sheet-like substrate.

It should be understood that, in the embodiments of the present invention, the sheet-like substrate may also have a compressible porous mesh structure in other directions perpendicular to the thickness direction, that is, the sheet-like substrate may have a porous spatial mesh structure so as to be more compressible and thermally conductive. For example, in the embodiment of the present invention, the sheet-like substrate may be an expandable graphite sheet, a foamed metal sheet, a graphene foam sheet, or the like. Further, it should be understood that, although the embodiment of the present invention is described through the example, the embodiments of the present invention are not limited to the example.

Therefore, the thermal pad made of the sheet-like substrate according to the embodiment of the present invention is highly compressible, so that, in a scenario in which multiple chips share a heat dissipater, the sheet-like substrate forming the thermal pad breaks off to fill the height difference or various tolerances between different chips, thereby implementing full contact between a heat emitting apparatus and a heat dissipater and improving heat dissipation between components; in another aspect, the thermal pad based on the embodiment of the present invention has a high thermal conductivity, which also significantly improves heat dissipation between the components.

Specifically, according to the embodiment of the present invention, a sheet thermal pad of both a high thermal conductivity and high compressibility can be manufactured. The sheet-like substrate may be made of materials such as graphite and graphene having a very high thermal conductivity, and the pore structures forming the sheet-like substrate are mutually connected. Therefore, compared with the existing prevalent practice in which spherical alumina is used as thermally conductive fillers, the sheet-like substrate in the embodiment of the present invention inherently has great advantages in terms of thermal conductivity. In another aspect, because the sheet-like substrate itself is of a porous structure, it can easily achieve high compressibility through an appropriate design of density and pore size. On the whole, the thermal pad based on the embodiment of the present invention can break through the performance bottleneck of the high thermal conductivity in the prior art, and produce compressible sheet-like thermal pads greater than or equal to 15 W/mK or even 30 W/mK.

The thermal pad based on the embodiment of the present invention can not only overcome the heat dissipation bottleneck of high-power heat emitting components in an electronic device, but more importantly, can also simplify structure design and reduce the assembly difficulty of a heat dissipater, reduce production costs of the heat dissipater, reduce the assembly difficulty of the heat dissipater, and enhance long-term reliability.

Further, according to the embodiment of the present invention, the sheet-like substrate is used as a raw material, which is easy to be compositely molded with organic resin and suitable for mass production. In particular, low-density expandable graphite is used as a sheet-like substrate. Because the costs of the low-density expandable graphite substrate are less than one tenth of the costs of the spherical alumina used as thermally conductive fillers, the low-density expandable graphite substrate can be used for cost-effectively fabricating compressible thermal pads with very high thermal conductivities.

It should be understood that, in the embodiment of the present invention, the thermal pad based on the embodiment of the present invention is a thermal interface material (Thermal Interface Material). The thermal interface material is also known as a thermally conductive interface material or an interface thermally conductive material, and is a material commonly used to dissipate heat for integrated circuit (Integrated Circuit, "IC" for short) packages and electronic devices. It is mainly used for filling micro voids or rough pores on the surface that are generated when two materials join up or contact, so as to reduce heat conduction impedance. Further, it should be understood that, in the industry, the thermal pad may also be called thermal silicone sheet, thermal silicone pad, thermal silicone pad, insulative thermal pad, soft thermal pad, or the like.

Due to a high thermal conductivity and high compressibility, the thermal pad in the embodiment of the present invention is suitable for filling in an interface to conduct heat when an assembly gap between a heat emitting component and the surface of the heat dissipater is greater than 0.1 mm, and is especially suitable for an application scenario in which the assembly tolerance between the heat emitting component and the surface of the heat dissipater is greater than or equal to $\pm 0.1$ mm, such as an application scenario in which multiple chips use the same heat dissipater.

The thermal pad in the embodiment of the present invention is completely different from the technical principles of the existing thermal interface materials in the prior art. In the prior art, thermally conductive fillers are added into a polymer substrate to achieve a higher thermal conductivity. In the embodiment of the present invention, the thermal pad is generated by adding, in the thickness direction, flexible and thermally conductive organic compounds in the interior or on the surface of the sheet-like substrate having a compressible porous mesh structure. For example, in the embodiment of the present invention, a sheet-like thermally conductive material is made by adding flexible and thermally conductive organic resin into a flexible and compressible substrate having a continuously heat-conducting mesh structure.

To achieve both high compressibility and high thermal conductivity of the thermal pad based on the embodiment of the present invention, the sheet-like substrate, in an aspect, needs to be of high thermal conductivity and compressibility, and in another aspect, the organic compound forming the coating needs to be of high thermal conductivity and compressibility. The following describes the sheet-like substrate and the organic compound forming the thermal pad.

In the embodiment of the present invention, because the substrate is ultimately used for making a sheet-like thermal interface material, the substrate itself may be made as a sheet; in another aspect, the long sheet-like substrate may even be wound into a roll, which is very suitable for mass production and thereby reduces production costs. The compatibility between the sheet-like substrate and the organic compound is a basis for making the thermal pad. The compatibility of the organic compound largely depends on inherent features of the materials forming the sheet-like substrate and on surface treatment for the pore structure and the pore wall.

The thermal conductivity and the compressibility of the thermal pad based on the embodiment of the present invention largely depend on the sheet-like substrate having a compressible porous mesh structure in the thickness direction. Both high thermal conductivity and high compressibility can be achieved when the sheet-like substrate has the following characteristics:

(1) The sheet-like substrate is of a porous structure, and pores are densely located inside the sheet-like substrate. The size, thickness and number of the pores affect the compressibility and thermal conductivity of the substrate. Generally, with more pores, the sheet-like substrate is more compressible.

(2) From a microscopic perspective, walls of adjacent pores in at least the thickness direction of the sheet-like substrate are interconnected to form a continuously heat-conducting mesh structure. Preferably, in the thickness direction of the sheet-like substrate and in a direction perpendicular to the thickness direction, the sheet-like substrate can have continuously heat-conducting mesh structures from the top down. When the sheet-like substrate is made of materials such as metal or carbon materials of high thermal conductivity, on which heat is primarily conducted through free electrons, the sheet-like substrate can have a high thermal conductivity.

(3) The sheet-like substrate is of a porous structure and is compressible.

Specifically, in the embodiment of the present invention, optionally, the thermal conductivity of the sheet-like substrate 110 is greater than or equal to 2 W/mK (watts per meter K). For example, the thermal conductivity of the sheet-like substrate 110 is 2 W/mK, 3 W/mK, 4 W/mK, 5 W/mK, 6 W/mK, 7 W/mK, 8 W/mK, 10 W/mK, 13 W/mK, 16 W/mK, 19 W/mK, 21 W/mK, 24 W/mK, 27 W/mK, or 30 W/mK. Optionally, the thermal conductivity of the sheet-like substrate 110 is greater than or equal to 3 W/mK.

Optionally, the thermal conductivity of the sheet-like substrate 110 falls within a range from 3 W/mK to 5 W/mK; or the thermal conductivity of the sheet-like substrate 110 falls within a range from 5 W/mK to 30 W/mK. For example, the thermal conductivity of the sheet-like substrate 110 falls within a range from 5 W/mK to 10 W/mK; or the thermal conductivity of the sheet-like substrate 110 falls within a range from 10 W/mK to 15 W/mK; or the thermal conductivity of the sheet-like substrate 110 falls within a range from 15 W/mK to 20 W/mK; or the thermal conductivity of the sheet-like substrate 110 falls within a range from 20 W/mK to 25 W/mK; or the thermal conductivity of the sheet-like substrate 110 falls within a range from 25 W/mK to 30 W/mK.

It should be understood that, in the embodiment of the present invention, the term "falling within a range from A to B" means being "greater than or equal to A " and "less than or equal to B". It should also be understood that, in the embodiment of the present invention, the specific value of a physical quantity measured by different instruments or by using different methods may vary slightly, or may be attributed to a certain conversion relationship. Although the values measured by the instruments or by using the methods provided in the embodiments of the present invention are used as examples of the values of each physical quantity, the embodiment of the present invention is not limited to the examples.

It should also be understood that in the embodiment of the present invention, the thermal conductivity of the sheet-like substrate 110 may be greater than or equal to 30 W/mK, which shall not constitute a limitation on the embodiment of the present invention.

In the embodiment of the present invention, optionally, the porosity of the sheet-like substrate 110 is greater than or equal to 50%. For example, the porosity of the sheet-like substrate 110 is 55%, 60%, 65%, 70%, 75%, 80%, 85%, 90%, 95%, or 99.8%. Optionally, the porosity of the sheet-like substrate 110 falls within a range from 80.0% to 99.8%. For example, the porosity of the sheet-like substrate 110 falls within a range from 80.0% to 85.0%; or the porosity of the sheet-like substrate 110 falls within a range from 85.0% to 90.0%; or the porosity of the sheet-like substrate 110 falls within a range from 90.0% to 95.0%; or the porosity of the sheet-like substrate 110 falls within a range from 95.0% to 99.8%.

It should be understood that, in the embodiment of the present invention, the porosity refers to a percentage of the volume of pores inside the sheet-like substrate to the total volume of the sheet-like substrate, and the porosity P of the sheet-like substrate may be expressed by the following equation (1):

$$P = \frac{V_0 - V}{V_0} \times 100\% = \left(1 - \frac{\rho_0}{\rho}\right) \times 100\% \qquad (1)$$

In the equation above, $V_0$ indicates the volume of the sheet-like substrate in natural status, including the entity of the sheet-like substrate and its open pores and closed pores; V indicates the absolutely compact volume of the sheet-like substrate; $\rho_0$ indicates the density of the sheet-like substrate in natural status, including the entity of the sheet-like substrate and its open pores and closed pores; and $\rho$ indicates the absolute compact density of the sheet-like substrate.

In the embodiment of the present invention, optionally, the pore size of the sheet-like substrate falls within a range from 60 PPI to 150 PPI. For example, the pore size of the sheet-like substrate is 70 PPI, 80 PPI, 90 PPI, 100 PPI, 110 PPI, 120 PPI, 130 PPI, or 140 PPI. Optionally, the pore size of the sheet-like substrate falls within a range from 90 PPI to 120 PPI; optionally, the pore size of the sheet-like substrate falls within a range from 100 PPI to 110 PPI. It should be understood that in the embodiment of the present invention, the pore size of the sheet-like substrate may be greater than 150 PPI, which shall not constitute a limitation on the embodiment of the present invention.

In the embodiment of the present invention, optionally, the material of the porous mesh structure of the sheet-like substrate 110 is a metal material or a carbon material. For example, the material of the porous mesh structure of the sheet-like substrate 110 is copper, aluminum, silver, carbon, graphite, or the like. Optionally, the sheet-like substrate 110 is an expandable graphite sheet, a foamed metal sheet, or a graphene foam sheet. The following describes the thermal pad 100 formed of the sheet-like substrate 110, assuming that the sheet-like substrate 110 is an expandable graphite sheet, a foamed metal sheet, or a graphene foam sheet.

In the embodiment of the present invention, optionally, the sheet-like substrate 110 is an expandable graphite sheet, the density of the expandable graphite sheet falls within a range from 0.1 g/cm$^3$ to 0.25 g/cm$^3$, the porosity of the sheet-like substrate 110 falls within a range from 89.0% to 96.0%, and the thermal conductivity of the thermal pad 100 falls within a range from 5 W/mK to 25 W/mK.

In the embodiment of the present invention, optionally, the sheet-like substrate 110 is a foamed copper sheet, the porosity of the foamed copper sheet falls within a range from 90.0% to 98.0%, and the pore size of the foamed copper sheet falls within a range from 90 PPI to 120 PPI; or

The sheet-like substrate 110 is a graphene foam sheet, the porosity of the graphene foam sheet falls within a range from 80.0% to 99.8%, and the pore size of the graphene foam sheet falls within a range from 90 PPI to 120 PPI.

It should be understood that, in the embodiment of the present invention, carbon and graphite materials are carbon-based non-metallic solid materials, where the carbon material is essentially formed of non-graphitic carbon, and the graphite material is essentially formed of graphitic carbon. For brevity, carbon and graphite materials are uniformly called carbon materials.

The porous sheet-like substrate has a rough surface, the sheet-like substrate may shatter in the application process, and some sheet-like substrates may flake off. Therefore, the sheet-like substrate cannot be directly used as a thermal interface material even if the sheet-like substrate is of high thermal conductivity and high compressibility. Therefore, an organic compound that soaks the surface, such as a polymer, needs to be compounded with the thermally conductive sheet-like substrate to overcome application disadvantages of the thermally conductive sheet-like substrate, thereby reducing the interfacial contact resistance and preventing flake-off of the substrate in the application process.

The organic compound, which is compounded with the thermally conductive sheet-like substrate, needs to be well flexible after being solidified, so that the sheet-like thermal pad made of the organic compound will not drastically deteriorate compressibility of the thermally conductive sheet-like substrate. The thermally conductive organic compound with a certain thermal conductivity needs to be very soft after being solidified, and even needs to have certain thixotropy and low hardness. Specifically, the organic compound needs to be somewhat flowable before being solidified, and can be solidified in a manner such as by heating or through ultraviolet (UltraViolet, "UV" for short). A filler polymer resin with a certain thermal conductivity may be used to enhance the thermal conductivity of the thermally conductive sheet-like substrate.

Filler polymer resins designed according to different formulas may differ in the thermal conductivity, flowability, and compressibility after being solidified. A key requirement of the embodiment of the present invention is that the organic compound such as a polymer resin needs to be high compressible after being solidified. Such a polymer resin, which is high compressible after being solidified, generally has a characteristic that the Tg point temperature (glass-forming transition temperature) is lower than the actual operating temperature of the material. For example, Tg is less than or equal to 80°C. Optionally, Tg is less than or equal to -30°C. Optionally, the Shore hardness of the solidified filler polymer resin (generally referred to as thermally conductive organic compound) needs to be less than Shore OO 60, and optionally, less than Shore OO 25.

Specifically, in the embodiment of the present invention, the thermal conductivity of the organic compound falls within a range from 0.5 W/mK to 6 W/mK. For example, the thermal conductivity of the organic compound falls within a range from 0.5 W/mK to 1 W/mK; or the thermal conductivity of the organic compound falls within a range from 1 W/mK to 2 W/mK; or the thermal conductivity of the organic compound falls within a range from 2 W/mK to 4 W/mK; or the thermal conductivity of the organic compound falls within a range from 4 W/mK to 6 W/mK. Optionally, the thermal conductivity of the organic compound falls within a range from 1 W/mK to 3 W/mK. For example, the thermal conductivity of the organic compound falls within a range from 1 W/mK to 2 W/mK; or the thermal conductivity of the organic compound falls within a range from 2 W/mK to 3 W/mK.

For example, the thermal conductivity of the organic compound is 0.8 W/mK, 1.2 W/mK, 1.6 W/mK, 2.0 W/mK, 2.4 W/mK, 2.8 W/mK, 3.2 W/mK, 3.6 W/mK, 4.0 W/mK, 4.4 W/mK, 4.8 W/mK, 5.2 W/mK, 5.6 W/mK, or 6 W/mK.

It should also be understood that in the embodiment of the present invention, the thermal conductivity of the organic compound may be greater than or equal to 6 W/mK, which shall not constitute a limitation on the embodiment of the present invention.

In the embodiment of the present invention, optionally, the Shore hardness of the coating 120 is less than or equal to Shore OO 60. For example, the Shore hardness of the coating 120 is Shore OO 55, Shore OO 50, Shore OO 45, Shore OO 40, Shore OO 35, Shore OO 30, Shore OO 25, Shore OO 20, Shore OO 15, Shore OO 10, or Shore OO 5. Optionally, the Shore hardness of the coating 120 is less than or equal to Shore OO 30. For example, the Shore hardness of the coating 120 is less than or equal to Shore OO 20.

In the embodiment of the present invention, optionally, the organic compound is a silicone resin system. For detailed technical implementation of the organic compound, reference may be made to the thermal pad and the thermal gel in the prior art. Optionally, the organic compound is polyacrylic acid, polyurethane or epoxy resin, or the like.

The thermal pad based on the embodiment of the present invention is applicable between a heat emitting component and a heat dissipating component. The manners of reducing the thermal resistance of the composite thermal pad are not only using the flexible and thermally conductive organic compound to fill on the surface or in the interior of the thermally conductive sheet-like substrate, but, in practical processing, but also are: controlling an average thickness of the flexible and thermally conductive organic compound on the surface of the compressible and thermally conductive sheet-like substrate. The thinner the thermally conductive organic compound is, the lower the thermal resistance caused by the thermally conductive organic compound is, and the lower the integrated thermal resistance of the composite thermal pad is. It should be understood that a part of the thermally conductive sheet-like substrate may be exposed on the surface of the composite thermal pad. In practical application, the exposed sheet-like substrate surface may directly contact the heat emitting component and the heat dissipating component to achieve lower thermal resistance.

In the embodiment of the present invention, optionally, the thickness of the coating that is coated on the surface of the sheet-like substrate 110 falls within a range from 1 $\mu$m to 0.5 mm. For example, the thickness of the coating 120 that is coated on the surface of the sheet-like substrate 110 falls within a range from 1 $\mu$m to 50 $\mu$m; or the thickness falls within a range from 50 $\mu$m to 100 $\mu$m; or the thickness falls within a range from 100 $\mu$m to 300 $\mu$m; or the thickness falls within a range from 300 $\mu$m to 0.5 mm. For example, the thickness of the coating 120 that is coated on the surface of the sheet-like substrate 110 is 2 $\mu$m, 5 $\mu$m, 10 $\mu$m, 30 $\mu$m, 50 $\mu$m, 70 $\mu$m, 100 $\mu$m, 200 $\mu$m, 300 $\mu$m, or 400 $\mu$m.

In the embodiment of the present invention, the quantity of the thermally conductive organic compound filled inside the compressible and thermally conductive sheet-like substrate may be strongly correlated with the size and number of pores, the flowability of the thermally conductive organic compound, composite process conditions (using vacuum-pumping as an example, degree and time of vacuum), and so on in the compressible and thermally conductive sheet-like substrate characterized by pores. In the embodiment of the present invention, the value range of the filling extent of the thermally conductive organic compound inside the compressible and thermally conductive sheet-like substrate may be from a value greater than 0 (0 indicates no filling) to a value corresponding to the porosity of the sheet-like substrate (if the filling extent is the porosity of the sheet-like substrate, the interior of the sheet-like substrate is fully filled). Such value range shall not be construed as a limitation on the embodiment of the present invention.

In the embodiment of the present invention, in the thickness direction, a thermally conductive sheet-like substrate 110 having a compressible porous mesh structure exists, and a thermally conductive coating 120 exists, where the thermally conductive coating is formed of a flexible organic compound that fills inside the sheet-like substrate 110 or is coated on the surface of the sheet-like substrate 110. In this way, the formed thermal pad 100 has high thermal conductivity as well as high compressibility.

Specifically, in the embodiment of the present invention, optionally, the thermal conductivity of the thermal pad 100 is greater than or equal to 3 W/mK. For example, the thermal conductivity of the thermal pad 100 is 6 W/mK, 9 W/mK, 12 W/mK, 15 W/mK, 18 W/mK, 21 W/mK, 24 W/mK, 27 W/mK, or 30 W/mK. Optionally, the thermal conductivity of the thermal pad 100 falls within a range from 3 W/mK to 5 W/mK.

Optionally, the thermal conductivity of the thermal pad 100 falls within a range from 5 W/mK to 15 W/mK. For example, the thermal conductivity of the thermal pad 100 falls within a range from 5 W/mK to 10 W/mK, or the thermal conductivity of the thermal pad 100 falls within a range from 10 W/mK to 15 W/mK. Optionally, the thermal conductivity of the thermal pad 100 falls within a range from 15 W/mK to 30 W/mK. For example, the thermal conductivity of the thermal pad 100 falls within a range from 15 W/mK to 20 W/mK; the thermal conductivity of the thermal pad 100 falls within a range from 20 W/mK to 25 W/mK, or the thermal conductivity of the thermal pad 100 falls within a range from 25 W/mK to 30 W/mK.

In the embodiments of the present invention, optionally, the Shore hardness of the thermal pad 100 is less than or equal to Shore A 60. For example, the Shore hardness of the thermal pad 100 is less than or equal to Shore A 20. Optionally, the Shore hardness of the thermal pad 100 is less than or equal to Shore OO 60. For example, the Shore hardness of the thermal pad 100 is Shore OO 55, Shore OO 50, Shore OO 45, Shore OO 40, Shore OO 35, Shore OO 30, Shore OO 25, Shore OO 20, Shore OO 15, or Shore OO 10. It should be understood that, the embodiment of the present invention is not limited to that.

In the embodiments of the present invention, optionally, the compressive stress of the thermal pad 100 is less than or equal to 100 psi under a 50% compression rate. For example, under a 50% compression rate, the compressive stress of the thermal pad 100 is 90 psi, 80 psi, 70 psi, 60 psi, 50 psi, 40 psi, 30 psi, 20 psi, or 10 psi. Optionally, under a 50% compression rate, the compressive stress of the thermal pad 100 is less than or equal to 150 psi; or, under a 50% compression rate, the compressive stress of the thermal pad 100 is less than or equal to 250 psi.

Therefore, in the thermal pad provided in the embodiments of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

In the embodiments of the present invention, a low-density expandable graphite sheet may be used as a thermally conductive substrate; a flexible silicone resin fills inside or on the surface of the substrate, and, after being solidified, the silicone resin can be molded to produce a thermally conductive sheet material.

Optionally, the density of the expandable graphite sheet falls within a range from 0.05 g/cm$^3$ to 0.5 g/cm$^3$. For example, when the density of the expandable graphite sheet decreases to 0.05 g/cm$^3$, the thermal conductivity is lower but the compressibility is higher; when the density of the expandable graphite sheet increases to 0.5 g/cm$^3$, the thermal conductivity is higher but the compressibility is lower. For example, the density of the expandable graphite sheet is 0.1 g/cm$^3$, 0.15 g/cm$^3$, 0.2 g/cm$^3$, 0.25 g/cm$^3$, 0.3 g/cm$^3$, 0.35 g/cm$^3$, 0.4 g/cm$^3$, or 0.45 g/cm$^3$.

The porosity of the expandable graphite sheet may be calculated according to the density. The porosity of the expandable graphite sheet may fall within a range from 80% to 97%. For example, when the density of the expandable graphite sheet is 0.1 g/cm$^3$, the porosity may be 96%; and, when the density of the expandable graphite sheet is from 0.2 to 0.25 g/cm$^3$, the porosity may be from 89% to 91 %.

Specifically, the expandable graphite itself, also known as graphite worms, is a porous material formed of graphite microcrystals. The graphite microcrystal retains a layered structure of graphite. In a direction parallel to the sheet layer, after being sp2-hybridized, a carbon atom combines with three adjacent carbon atoms through a σ key, and are arranged in a planar mesh structure; the binding force between microcrystals is weak, and microcrystals are bound together through a van der Waals force. Through oxidation and intercalation, a natural flake graphite forms a graphite intercalation compound (GICs). After being subjected to a certain high temperature, the graphite intercalation compound expands. The spacing of the microcrystals expands sharply along a C-axis direction perpendicular to the graphite sheet until the size expands hundreds of times to form wormlike expandable graphite. The expandable graphite is known as expandable graphite or graphite worm, and the graphite changes from an original flaky shape to a worm shape of a very low density to form a very good heat insulation layer. The expandable graphite is both a carbon source in the expansion system and an heat insulation layer, and can effectively isolate heat and is characterized by low emission of heat, low mass loss, and low emission of fumes in the fire. Although the expandable graphite is an existing mature material, the present invention differs from the prior art with respect to the application of the expandable graphite (insulation, adsorption, or grinding into flakes as a thermally conductive filler), but presses the wormlike expandable graphite to produce a sheet-like expandable graphite of a certain density and a certain thickness.

Little research is performed on thermal conductivity of the expandable graphite, and the use of the thermal conductivity of the expandable graphite is less. In the prior art, the expandable graphite is pressed into a flexible graphite sheet, where the density of the graphite sheet is greater than 1.0 g/cm$^3$ and the thermal conductivity on the x plane and the y plane is greater than 200 W/mK, so that the graphite sheet can be used for transmitting heat at local heat sources of an electronic device. However, such a flexible graphite sheet is not compressible.

The embodiment of the present invention uses a low-density expandable graphite sheet as a thermally conductive substrate. The thermal conductivity and the compressibility of the expandable graphite sheet largely depend on the density, but the pressing method, the material design of the graphite intercalation compound, and the high temperature expansion process also impose certain impact on thermal conductivity and compressibility of the sheet-like expandable graphite.

The traditional expandable graphite uses strong acid as an intercalator. Corrosive substances such as S and Cl exist in the process of using such expandable graphite, so that it is not suitable for electronic devices. A sulfur-free expandable graphite system is preferred. The expansion temperature of the traditional expandable graphite is from 800°C to 1000°C. Under a high temperature, carbon loss is high, so that the traditional expandable graphite is not good for making a sheet-like expandable graphite substrate having a high thermal conductivity. A cryogenic expansion process is preferred.

For example, assuming that ammonium phosphate is used as an auxiliary intercalator to manufacture an expandable graphite sheet, the method of fabricating a thermally conductive sheet-like substrate according to the embodiment of the present invention is described below, where the sheet-like substrate has a compressible porous mesh structure in the thickness direction. However, the embodiment of the present invention is not limited to the example.

The specific method may be as follows: Use a 50-mesh natural flake graphite as a raw material, use a concentrated sulfuric acid as an intercalator, use an ammonium phosphate as an auxiliary intercalator, and use potassium permanganate as an oxidant; according to the percentage of $KMnO_4:H_2SO_4$ (96%):$(NH_4)_3PO_4$ = 1:0.2:3.0:0.45, use a pipette to measure and pick up a specific volume of $H_2SO_4$ (96%) and put it into a beaker, dilute the solution to a mass fraction of 75%, let the solution stand to a room temperature, and then add the ammonium phosphate, graphite, and potassium permanganate into the solution in sequence; place the solution in a thermostatic bath of a specified temperature to react for 60 minutes, and keep stirring to ensure uniform reaction; after the reaction is finished, wash the product and soak the product for 2 hours until the pH value is 6-7, and until the washing liquid has no color of the potassium permanganate solution, transfer the product into an evaporating dish, and place the product into an oven for drying at a temperature from 50°C to 70°C for a specific duration; after being completely dried, the product becomes a highly expandable graphite whose initial expansion temperature is 165°C and whose swelling volume is 400 mL/g; in the 165°C oven, heat the product for 30 minutes to obtain a highly expandable graphite. By using a press mold, the expandable graphite can be compressed into a 0.1 g/cm$^3$ sheet-like expandable graphite sheet.

In summary, the specific fabricating process may include: A flake graphite, an oxidant, and an intercalator undergo an oxidization and intercalation reaction process, a washing and filtration process, a drying process, a high temperature expansion process, and a pressing process to form a low-density expandable graphite sheet. It should also be understood that expandable graphite sheets of other densities may be obtained by changing conditions of the pressing process or conditions of other processes, which shall not be construed as a limitation on the embodiment of the present invention.

It should also be understood that in the embodiment of the present invention, for the method of testing the thermal conductivity, the method of testing the compressive stress at a certain compression rate, and the test devices and test conditions, reference may be made to the following methods. Although the embodiment of the present invention uses them as examples, the embodiment of the present invention is not limited to the examples. In the method of testing the thermal conductivity, the thermal resistance of a sample is tested under the conditions of ASTM D 5470 and 10 psi, 20 psi, 30 psi, 40 psi, and 50 psi, Longwin LW9389 is used as a test device. Through fitting, an equivalent thermal conductivity is obtained. In the method of testing the compressive stress, an Instron mechanical testing machine is applied, a 25 mm x 25 test sample is disposed on a horizontal bench of the mechanical testing machine, a 25 mm x 25 mm press head is applied to compress the test sample downward at a speed of 25 mm/min, and the compressive stress of the thermal pad under different compression rates is recorded.

As measured, when the density of the sheet-like expandable graphite is 0.1 g/cm$^3$ (the porosity is about 96%), the thermal conductivity in the thickness direction is about 5 W/mK, the expandable graphite is highly compressible, and the compressive stress is less than 100 psi when the compression rate is 50%. When the density of the sheet-like expandable graphite is from 0.2 to 0.25 g/cm$^3$ (the porosity is from about 89% to 91 %), the thermal conductivity in the thickness direction is up to from 15 to 25 W/mK, and the compressive stress is less than 150 psi when the compression rate is 50%. As regards the silicone thermal pad commonly used in the industry nowadays, alumina fillers that account for over 60% of weight are added into silicone resins, resulting in a compressive stress greater than 150 psi under a thermal conductivity of 3 W/mK and the compression rate of 50%. When the thermal conductivity is 5 W/mK, such a thermal pad is scarcely applied due to too high compressive stress.

However, such a low-density expandable graphite has a low mechanical strength and tends to break, resulting in electrically conductive scraps. Due to the problem of shedding the electrically conductive scraps, the low-density expandable graphite sheet is not directly used as a thermal interface material.

As assessed, the expandable graphite is well compatible with most organic resins. It is very easy to apply a layer of silicone compounds around the expandable graphite sheet by using a conventional technique such as coating and printing. Under certain process conditions, silicone resins that are not solidified can penetrate into low-density expandable graphite materials.

For example, the expandable graphite powder may undergo a process such as heat expansion or press to produce sheet-like expandable graphite of 25mm(L) x 25mm(W) x 2.5mm(H) dimensions and the 0.1 g/cm$^3$ density. For example, the sheet-like expandable graphite may be disposed in a container. Silicone resin components A and B, which are fully blended evenly, are added into the container in sequence. Component A may be a mixture of ethylene-containing polysiloxane and a Pt-based catalyst, where the ethylene-containing polysiloxane contains spherical alumina fillers of different particle sizes; and component B may be a mixture of silicon-hydrogen bond-containing oligomeric polysiloxane and other additives, where the silicon-hydrogen bond-containing oligomeric polysiloxane contains spherical alumina fillers of different particle sizes. After the silicone resin components A and B are solidified normally (under 120°C for 30 minutes), the thermal conductivity is 1.15 W/mK, and the hardness is less than Shore OO 20. The container may be disposed in a vacuum device. With the progress of vacuum pumping, it is visible that the liquid level of silicone descends, indicating that the silicone has penetrated into the expandable graphite substrate to some extent. For example, after 30 minutes of heating under a preset heat-hardening temperature of 120°C, the silicone resin can be solidified into a thermally conductive composite sheet filled with 1.15 W/mK thermally conductive flexible silicone compounds inside and on the surface.

The thermal conductivity of the thermally conductive composite sheet is tested in the thickness direction by using the following method: According to an ASTM D 5470 test annotation, a Longwin LW9389 device is applied, and the thermal conductivities in a z direction of samples are all greater than 5.5 W/mK. Meanwhile, the test device for testing the instantaneous maximum compressive stress under a 50% compression rate is an Instron mechanical testing machine. The test method is: Place the thermally conductive sheet on a horizontal bench of the mechanical testing machine, a 25mm*25mm press head is applied to compress the thermally conductive sheet downward at a speed of 25 mm/min, and the compressive stress of the thermal pad under different compression rates is recorded. For the samples, the compressive stress under a 50% compression rate should be all less than 120 psi. According to the above embodiments and test results, after being compounded with a thermally conductive silicone material, the sheet-like expandable graphite has a higher thermal conductivity, the compressive stress is slightly higher but still acceptable, and the problem of shedding electrically conductive scraps is solved.

In the embodiment of the present invention, it should be understood that the worm-like expandable graphite is always orientative in the pressing process. Generally, pressed expandable graphite is well orientative and has a high thermal conductivity on the horizontal plane (the x and y directions), and the thermal conductivity in the thickness direction (the z direction) is about 1/20 of the thermal conductivity in the x and y planes. The present invention needs to make use of the thermal conductivity of the sheet-like thermally conductive material in the thickness direction. In the pressing process, technical conditions of the pressing may be changed to appropriately increase the thermal conductivity in the thickness direction.

For example, if the thermal conductivity in the length and width directions of the sheet-like substrate is far higher than the thermal conductivity in the thickness direction, in order to take advantage of the high thermal conductivity in the length and width directions of the sheet-like substrate, before or after the sheet-like substrate is compounded with the organic resin, multiple layers of the sheet-like substrate may be overlaid or wound to produce the thermally conductive composite material that can be bonded together, which is then cut along the thickness direction or radial direction. Generally, such a fabricating method can change the initial highly heat-conducting direction of the sheet-like substrate to the thickness direction of the final sheet-like thermally conductive material.

Because the thermally conductive compressible substrate is generally brittle, scraps tend to flake off. No definite limitation is imposed on the cutting method or the cutting tool. A single-blade cutting method is preferred, but laser cutting, water jet cutting, multi-blade cutting, and other cutting methods are also acceptable. An operating temperature and a detailed approach during cutting are crucial. It is recommended that a compounded thermal pad be cooled down under a temperature from -40°C to 5°C before cutting the thermal pad, or, a component to be cut be cooled down under a temperature from -60°C to 5°C before the compounded thermal pad is cut. The recommended operating temperature range of the cutting is a range from Tg -20°C to Tg +20°C of the material. The above method can avoid cutting scraps, and generate a smooth cutting face.

In the embodiment of the present invention, a perforated foamed metal may be used as a thermally conductive sheet-like substrate; flexible silicone resin fills inside or on the surface of the thermally conductive sheet-like substrate. After being solidified, the silicone resin is molded to produce a sheet-like thermal pad.

Optionally, the sheet-like substrate is a foamed copper sheet, the porosity of the foamed copper sheet falls within a range from 90.0% to 98.0%, and the pore size of the foamed copper sheet falls within a range from 90 PPI to 120 PPI. For example, the porosity of the foamed copper sheet falls within a range from 95.0% to 98.0%.

Currently perforated foamed metals include foamed aluminum, foamed nickel, foamed copper, and the like, which are primarily used for denoising and filtration and used as catalyst carriers and heat exchangers. By virtue of their three-dimensional mesh structure, foamed metals are used as two-phase heat exchangers to help two-phase heat exchange. Foamed copper is preferred because the thermal conductivity of copper is high. By referring to a technique of fabricating foamed copper in the prior art, sheet-like foamed copper can be manufactured in batches after an organic foamed substrate undergoes a series of processes such as activation, copper plating, removal of organic materials, and the like. Generally, the organic foamed substrate is very soft and highly compressible. The foamed copper maintains a three-dimensional mesh framework and is highly compressible, and is thermally conductive to some extent because the porous mesh structure is formed of copper metal.

The thermal conductivity and compressibility of the foamed copper depend on the porosity and pore density of the foamed copper. For example, the foamed copper has a thickness of 2.5 mm, a surface density of 650 $g/m^2$, a porosity

of about 97%, and a pore size of 90 PPI. As tested, the thermal conductivity in the thickness direction may be 5.3 W/mK, and the compressive stress under a 50% compression rate is 50% of the compressive stress of a conventional 3W/mK silicone thermal pad. This foamed copper has a rough surface, metal scraps may be shedding, and copper is vulnerable to corrosion when exposed to air, which deteriorates thermal conductivity in the long-term application. Therefore, the foamed copper cannot be directly used as a thermal interface material.

The foamed copper has a visible pore structure. The organic resin of certain flowability can fill inside or on the surface of the foamed copper substrate under certain conditions. A flexible silicone resin with a thermal conductivity of 1.2 W/mK is coated on the surface of the 90 PPI foamed copper having a surface density of 650 $g/m^2$, and partly fills inside the foamed copper, and is made into a sheet-like foamed copper-based composite thermal pad after being solidified. As tested, the thermal conductivity of the sheet-like thermal pad in the thickness direction is greater than or equal to 5.8 W/mK, and the compressive stress under a 50% compression rate increases by less than 50% compared with the foamed copper substrate. After being compounded with a thermally conductive silicone material, the foamed copper substrate has a higher thermal conductivity, the compressive stress is slightly higher but still acceptable, and the problem of shedding electrically conductive scraps is solved.

The foamed copper-based composite thermal pad is equivalent to the foamed copper substantially coated by a silicone material. Because the silicone material is hydrophobic, the speed of corrosion and aging of the foamed copper is lowered. In practice, a highly corrosion-resistant metal layer such as nickel may be plated in the foamed copper substrate, which, however, shall not be construed as a limitation on the embodiment of the present invention.

In the embodiment of the present invention, a sheet-like graphene material with a perforated foam structure may be used as a thermally conductive substrate; flexible silicone resin fills inside or on the surface of the substrate, and after being solidified, the silicone resin can be molded into a thermally conductive sheet material.

Optionally, the sheet-like substrate 110 is a graphene foam sheet, the porosity of the graphene foam sheet falls within a range from 80.0% to 99.8%, and the pore size of the graphene foam sheet falls within a range from 90 PPI to 120 PPI. For example, the porosity of the graphene foam sheet falls within a range from 90.0% to 99.8%.

The sheet-like graphene with a perforated foam structure applied in the embodiment of the present invention has a three-dimensional mesh structure, and the mesh structure is constructed of a graphene material. As a material of the highest thermal conductivity currently, graphene has a theoretical thermal conductivity of up to 5000 W/mK. Due to the high thermal conductivity of the graphene, the graphene can still have a high thermal conductivity even when the pore wall is very thin. Due to the very thin pore wall of the graphene, the formed sheet-like graphene foam material is highly compressible, and its compressive stress is ignorable in the application of thermal interface materials.

According to a conventional graphene foam technique, graphene may be manufactured by applying chemical vapor deposition (CVD) on the foamed nickel, and then the metal is removed, thereby producing a sheet-like foam graphene material with a three-dimensional continuously thermal-conducting mesh structure, whose porosity is about 99%. As measured, the thermal conductivity of the foamed graphene material is about 2W/mK, and the compressive stress of the material may be less than 10 psi under a 50% compression rate. As regards the graphene foam produced by using the CVD method, the density is very low, the porosity is too high, and the carbon content is too low, resulting in a too low thermal conductivity. By increasing the density of the graphene, it is practicable to make a thermally conductive substrate having a high thermal conductivity and very low compressive stress.

The sheet-like thermal pad in the embodiment of the present invention is a made by using organic resins to fill inside or on the surface of the sheet-like substrate having a continuously heat-conducting mesh structure. After being solidified, the organic resins are well flexible, and can be made into a thermally conductive sheet material. Because the pore wall structure forming the mesh structure is somewhat orientative, some sheet-like substrates have different thermal conductivities in different directions. That is, the thermal conductivity in the thickness direction (the z direction) is different from the thermal conductivity in the length and width directions (the x and y directions). Using the low-density expandable graphite sheet as an example, the graphitic microcrystalline lamellar structure is generally highly orientative on the x and y planes, so that the thermal conductivity on the x and y planes is significantly higher than the thermal conductivity in the z direction.

In order to take advantage of the high thermal conductivities in the length and width directions of the sheet-like substrate, before or after the sheet-like substrate is compounded with organic resins, multiple layers of the sheet-like substrate may be overlaid or wound to produce the thermally conductive composite material that can be bonded together, which is then cut along the thickness direction or radial direction. Generally, such a fabricating method can change the initial highly heat-conducting direction of the sheet-like substrate to the thickness direction of the final sheet-like thermally conductive material.

It should be understood that the sheet-like substrate has a porous structure, the organic resins are highly flowable and can easily fill inside or on the surface of the sheet-like substrate under specific temperatures and forces by means of potting, painting, coating, adsorption, deposition, and the like, and then the organic resin is solidified under hardening conditions to produce a thermally conductive sheet material. Therefore, through a variety of conventional techniques, the sheet-like substrate can be easily compounded and molded with the organic resins. Although the embodiment of the present invention does not profoundly describe the methods of compounding and molding the sheet-like substrate with the organic resins, but the embodiment of the present invention is not limited to such methods.

Therefore, in the thermal pad provided in the embodiments of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

An embodiment of the present invention further provides a method for fabricating a thermal pad. As shown in FIG. 2, the method 300 for fabricating a thermal pad in the embodiment of the present invention includes:

S310. Provide a thermally conductive sheet-like substrate, where the sheet-like substrate has a compressible porous mesh structure in a thickness direction.

S320. Provide a thermally conductive and flexible organic compound.

S330. Use the organic compound to fill inside the sheet-like substrate or coat on a surface of the sheet-like substrate, or use the organic compound to both fill inside the sheet-like substrate and coat on the surface of the sheet-like substrate to form the thermal pad.

Therefore, in the method for fabricating a thermal pad provided in the embodiment of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of an electronic device.

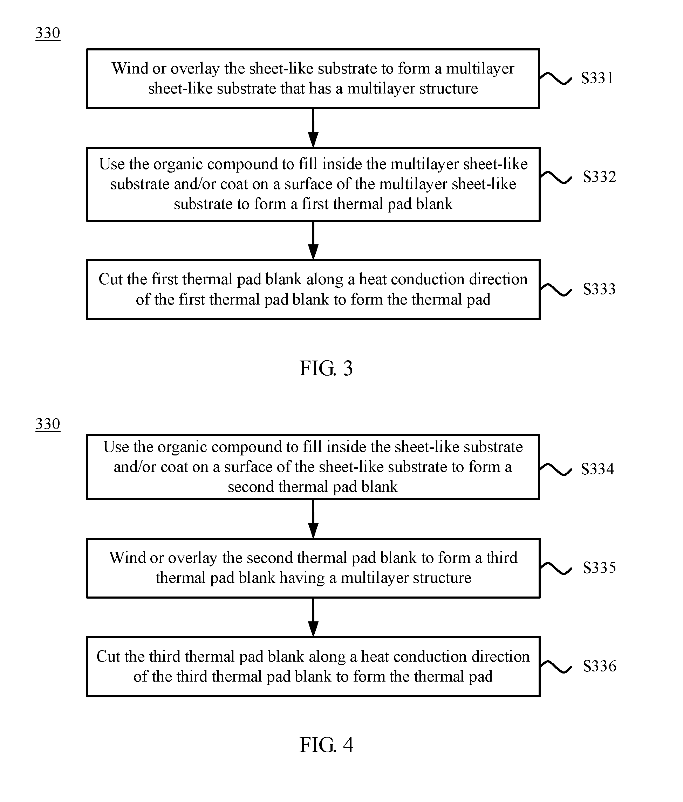

In the embodiment of present invention, optionally, as shown in FIG. 3, S330 in FIG. 2, that is, using the organic compound to fill inside the sheet-like substrate or coat on a surface of the sheet-like substrate or using the organic compound to both fill inside the sheet-like substrate and coat on the surface of the sheet-like substrate to form the thermal pad, includes:

S331. Wind or overlay the sheet-like substrate to form a multilayer sheet-like substrate with a multilayer structure.

S332. Use the organic compound to fill inside the multilayer sheet-like substrate or coat on a surface of the multilayer sheet-like substrate to form a first thermal pad blank.

S333. Cut the first thermal pad blank along a heat conduction direction of the first thermal pad blank to form the thermal pad.

In the embodiment of present invention, optionally, as shown in FIG. 4, S330 in FIG. 2, that is, using the organic compound to fill inside the sheet-like substrate or coat on a surface of the sheet-like substrate or using the organic compound to both fill inside the sheet-like substrate and coat on the surface of the sheet-like substrate to form the thermal pad, includes:

S334. Use the organic compound to fill inside the sheet-like substrate or coat on the surface of the sheet-like substrate, or use the organic compound to both fill inside the sheet-like substrate and coat on the surface of the sheet-like substrate to form a second thermal pad blank.

S335. Wind or overlay the second thermal pad blank to form a third thermal pad blank with a multilayer structure.

S336. Cut the third thermal pad blank along a heat conduction direction of the third thermal pad blank to form the thermal pad.

In the embodiment of the present invention, optionally, the thermal conductivity of the sheet-like substrate is greater than or equal to 2 W/mK; or the thermal conductivity of the thermal pad falls within a range from 5 W/mK to 30 W/mK.

In the embodiment of the present invention, optionally, the porosity of the sheet-like substrate is greater than 50%; or the porosity of the sheet-like substrate falls within a range from 80.0% to 99.8%.

In the embodiment of the present invention, optionally, the porous mesh structure of the sheet-like substrate is made of a metal material or a carbon material, or the sheet-like substrate is made of an expandable graphite sheet, a foamed metal sheet, or a graphene foam sheet.

In the embodiment of the present invention, optionally, the thermal conductivity of the organic compound falls within a range from 0.5 W/mK to 6 W/mK; or the thermal conductivity of the organic compound falls within a range from 1 W/mK to 3 W/mK.

In the embodiment of the present invention, optionally, the Shore hardness of the organic compound is less than or equal to Shore OO 60 after the organic compound is solidified; or the Shore hardness of the organic compound is less than or equal to Shore OO 30 after the organic compound is solidified.

It should be understood that in various embodiments of the present invention, the serial numbers of the above process do not mean the order of implementation, and the implementation order of the processes depends on their functionalities and internal logics and shall not constitute any limitation on the implementation process of the embodiments of the present invention.

It should also be understood that the foregoing features or other features of the sheet-like substrate and the organic compound provided in the embodiments of the present invention are the same as or correspond to those of the sheet-like substrate 110 and the organic compound forming the coating 120. For brevity, these features are not repeated here any further.

Therefore, in the method for fabricating a thermal pad provided in the embodiments of the present invention, a thermally conductive flexible organic compound fills or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

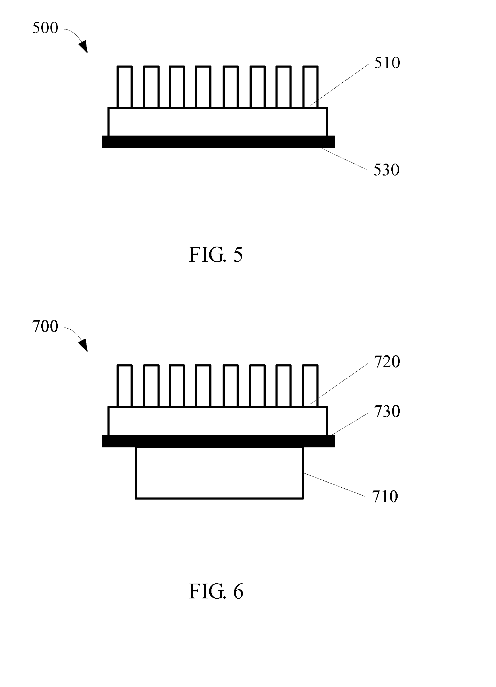

An embodiment of the present invention further provides a heat dissipating apparatus. As shown in FIG. 5, a heat dissipating apparatus 500 in the embodiment of the present invention includes:

a heat dissipating component 510; and
a thermal pad 530 disposed between the heat dissipating component 510 and a heat emitting component according to an embodiment of the present invention, or a thermal pad 530 manufactured according to a method disclosed in an embodiment of the present invention, where
the thermal pad includes: a thermally conductive sheet-like substrate, where the sheet-like substrate has a compressible porous mesh structure in a thickness direction; and a thermally conductive coating, where the coating is formed of a flexible organic compound, and the organic compound fills inside the sheet-like substrate or is coated on a surface of the sheet-like substrate, or the organic compound both fills inside the sheet-like substrate and is coated on the surface of the sheet-like substrate; and
a method for fabricating a thermal pad includes: providing a thermally conductive sheet-like substrate, where the sheet-like substrate has a compressible porous mesh structure in a thickness direction; and providing a thermally conductive and flexible organic compound, and using the organic compound to fill inside the sheet-like substrate or coat on a surface of the sheet-like substrate, or using the organic compound to both fill inside the sheet-like substrate and coat on the surface of the sheet-like substrate to form the thermal pad.

It should be understood that the thermal pad 530 included in the heat dissipating apparatus 500 according to the embodiment of the present invention may correspond to a thermal pad 100 based on an embodiment of the present invention, or a thermal pad manufactured according to a method 300 for fabricating a thermal pad; and the sheet-like substrate included in the thermal pad 530 and the organic compound forming the coating are the same as or correspond to the sheet-like substrate and the organic compound of the thermal pad 100 based on the embodiment of the present invention or the thermal pad manufactured according to the method 300 for fabricating a thermal pad. For brevity, they are not repeated here any further.

Therefore, in the heat dissipating apparatus in the embodiment of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

As shown in FIG. 6, an embodiment of the present invention further includes an electronic device. The electronic device 700 based on the embodiment of the present invention includes:

a heat emitting component 710;
a heat dissipating component 720; and
a thermal pad 730 disposed between the heat emitting component 710 and the heat dissipating component 720 according to an embodiment of the present invention, or a thermal pad 730 manufactured according to a method disclosed in an embodiment of the present invention, where
the thermal pad includes: a thermally conductive sheet-like substrate, where the sheet-like substrate has a compressible porous mesh structure in a thickness direction; and a thermally conductive coating, where the coating is formed of a flexible organic compound, and the organic compound fills inside the sheet-like substrate or is coated on a surface of the sheet-like substrate, or the organic compound both fills inside the sheet-like substrate and is coated on the surface of the sheet-like substrate; and
a method for fabricating a thermal pad includes: providing a thermally conductive sheet-like substrate, where the sheet-like substrate has a compressible porous mesh structure in a thickness direction; and providing a thermally conductive and flexible organic compound, and using the organic compound to fill inside the sheet-like substrate or coat on a surface of the sheet-like substrate, or using the organic compound to both fill inside the sheet-like substrate and coat on the surface of the sheet-like substrate to form the thermal pad.

It should be understood that the thermal pad 730 included in the heat dissipating apparatus 700 according to the embodiment of the present invention may correspond to a thermal pad 100 based on an embodiment of the present invention, or a thermal pad manufactured according to a method 300 for fabricating a thermal pad; and the sheet-like substrate included in the thermal pad 730 and the organic compound forming the coating are the same as or correspond to the sheet-like substrate and the organic compound of the thermal pad 100 based on the embodiment of the present invention or the thermal pad manufactured according to the method 300 for fabricating a thermal pad. For brevity, they are not repeated here any further.

Therefore, in the electronic device in the embodiment of the present invention, a thermally conductive flexible organic compound fills inside or is coated on a thermally conductive sheet-like substrate having a compressible porous mesh structure in the thickness direction, so that the formed thermal pad has high thermal conductivity as well as high compressibility, and therefore can improve heat dissipation performance of the electronic device.

A person of ordinary skill in the art may appreciate that, in combination with the examples described in the embodiments disclosed in this specification, units and algorithm steps may be implemented by electronic hardware, computer software, or a combination thereof. In order to clearly describe the interchangeability between the hardware and the software, the foregoing has generally described compositions and steps of every embodiment according to functions. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

It may be clearly understood by a person skilled in the art that, for the purpose of convenient and brief description, for a detailed working process of the foregoing system, apparatus and unit, reference may be made to the corresponding process in the method embodiments, and the details are not described herein again.

In the several embodiments provided in the present application, it should be understood that the disclosed system, apparatus, and method may be implemented in other manners. For example, the described apparatus embodiment is merely exemplary. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections are implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. A part or all of the units herein may be selected according to the actual needs to achieve the objectives of the solutions of the embodiments of the present invention.

In addition, functional units in the embodiments of the present invention may be integrated into a processing unit, or each of the units may exist alone physically, or two or more units may be integrated into a unit. The integrated unit may be implemented in a form of hardware, or may be implemented in a form of a software functional unit.

When the integrated unit are implemented in a form of a software functional unit and sold or used as a standalone product, the integrated unit may be stored in a computer-readable storage medium. Based on such an understanding, the technical solutions of the present invention essentially, or the part contributing to the prior art, or all or a part of the technical solutions may be implemented in the form of software product. The computer software product is stored in a storage medium and includes several instructions for instructing a computer device (which may be a personal computer, a server, or a network device) to execute all or a part of steps of the method described in the embodiments of the present invention. The foregoing storage medium includes: any medium that can store program codes, such as a USB flash disk, a removable hard disk, a read-only memory (Read-Only Memory, ROM), a random access memory (Random Access Memory, RAM), a magnetic disk, or an optical disc.

The foregoing descriptions are merely exemplary embodiments of the present invention, but are not intended to limit the protection scope of the present invention. Any equivalent modification or replacement figured out by a person skilled in the art within the technical scope of the present invention shall fall within the protection scope of the present invention. Therefore, the protection scope of the present invention shall be subject to the protection scope of the claims.

## Claims

1. A thermal pad, comprising:

    a thermally conductive sheet-like substrate, wherein the sheet-like substrate has a compressible porous mesh structure in a thickness direction; and
    a thermally conductive coating, wherein the coating is formed of a flexible organic compound, wherein
    the organic compound fills inside the sheet-like substrate or is coated on a surface of the sheet-like substrate, or the organic compound both fills inside the sheet-like substrate and is coated on a surface of the sheet-like substrate.

2. The thermal pad according to claim 1, wherein a thermal conductivity of the thermal pad is greater than or equal to 3 W/mK; or
a thermal conductivity of the thermal pad falls within a range from 3 W/mK to 5 W/mK; or
a thermal conductivity of the thermal pad falls within a range from 5 W/mK to 15 W/mK; or
a thermal conductivity of the thermal pad falls within a range from 15 W/mK to 30 W/mK.

3. The thermal pad according to claim 1, wherein a Shore hardness of the thermal pad is less than or equal to Shore A 60; or
a Shore hardness of the thermal pad is less than or equal to Shore OO 60.

4. The thermal pad according to claim 1, wherein a compressive stress of the thermal pad under a 50% compression rate is less than or equal to 100 psi; or
a compressive stress of the thermal pad under a 50% compression rate is less than or equal to 150 psi; or
a compressive stress of the thermal pad under a 50% compression rate is less than or equal to 250 psi.

5. The thermal pad according to any one of claims 1 to 4, wherein a thermal conductivity of the sheet-like substrate is greater than or equal to 2 W/mK; or
a thermal conductivity of the sheet-like substrate falls within a range from 5 W/mK to 30 W/mK.

6. The thermal pad according to any one of claims 1 to 4, wherein a porosity of the sheet-like substrate is greater than or equal to 50%; or
a porosity of the sheet-like substrate falls within a range from 80.0% to 99.8%.

7. The thermal pad according to any one of claims 1 to 4, wherein the porous mesh structure of the sheet-like substrate is made of a metal material or a carbon material.

8. The thermal pad according to claim 7, wherein the sheet-like substrate is an expandable graphite sheet, a foamed metal sheet, or a graphene foam sheet.

9. The thermal pad according to any one of claims 1 to 4, wherein a thermal conductivity of the organic compound falls within a range from 0.5 W/mK to 6 W/mK; or
a thermal conductivity of the organic compound falls within a range from 1 W/mK to 3 W/mK.

10. The thermal pad according to any one of claims 1 to 4, wherein a Shore hardness of the coating is less than or equal to Shore OO 60; or
a Shore hardness of the coating is less than or equal to Shore OO 30.

11. The thermal pad according to any one of claims 1 to 4, wherein a thickness of the coating that is coated on the surface of the sheet-like substrate falls within a range from 1 $\mu$m to 0.5 mm.

12. The thermal pad according to claim 8, wherein: the sheet-like substrate is an expandable graphite sheet, a density of the expandable graphite sheet falls within a range from 0.1 g/cm$^3$ to 0.25 g/cm$^3$, a porosity of the sheet-like substrate falls within a range from 89.0% to 96.0%, and the thermal conductivity of the thermal pad falls within a range from 5 W/mK to 25 W/mK.

13. The thermal pad according to claim 8, wherein: the sheet-like substrate is a foamed copper sheet, a porosity of the foamed copper sheet falls within a range from 90.0% to 98.0%, and a pore size of the foamed copper sheet falls within a range from 90 PPI to 120 PPI; or
the sheet-like substrate is a graphene foam sheet, a porosity of the graphene foam sheet falls within a range from 80.0% to 99.8%, and a pore size of the graphene foam sheet falls within a range from 90 PPI to 120 PPI.

14. A method for fabricating a thermal pad, comprising:

providing a thermally conductive sheet-like substrate, wherein the sheet-like substrate has a compressible porous mesh structure in a thickness direction;
providing a thermally conductive and flexible organic compound; and
using the organic compound to fill inside the sheet-like substrate or coat on a surface of the sheet-like substrate, or using the organic compound to both fill inside the sheet-like substrate and coat on the surface of the sheet-like substrate to form the thermal pad.

15. The method according to claim 14, wherein: the using the organic compound to fill inside the sheet-like substrate or coat on a surface of the sheet-like substrate, or using the organic compound to both fill inside the sheet-like substrate and coat on the surface of the sheet-like substrate to form the thermal pad, comprises:

winding or overlaying the sheet-like substrate to form a multilayer sheet-like substrate with a multilayer structure;
using the organic compound to fill inside the sheet-like substrate or coat on the surface of the sheet-like substrate, or using the organic compound to both fill inside the sheet-like substrate and coat on the surface of the sheet-like substrate to form a first thermal pad blank; and
cutting the first thermal pad blank along a heat conduction direction of the first thermal pad blank to form the thermal pad.

16. The method according to claim 14, wherein: the using the organic compound to fill inside the sheet-like substrate or coat on a surface of the sheet-like substrate, or using the organic compound to both fill inside the sheet-like substrate and coat on the surface of the sheet-like substrate to form the thermal pad, comprises:

using the organic compound to fill inside the sheet-like substrate or coat on the surface of the sheet-like substrate, or using the organic compound to both fill inside the sheet-like substrate and coat on the surface of the sheet-like substrate to form a second thermal pad blank; and
winding or overlaying the second thermal pad blank to form a third thermal pad blank with a multilayer structure; and
cutting the third thermal pad blank along a heat conduction direction of the third thermal pad blank to form the thermal pad.

17. The method according to any one of claims 14 to 16, wherein a thermal conductivity of the sheet-like substrate is greater than or equal to 2 W/mK; or
a thermal conductivity of the sheet-like substrate falls within a range from 5 W/mK to 30 W/mK.

18. The method according to any one of claims 14 to 16, wherein a porosity of the sheet-like substrate is greater than or equal to 50%; or
a porosity of the sheet-like substrate falls within a range from 80.0% to 99.8%.

19. The method according to any one of claims 14 to 16, wherein the porous mesh structure of the sheet-like substrate is made of a metal material or a carbon material; or
the sheet-like substrate is an expandable graphite sheet, a foamed metal sheet, or a graphene foam sheet.

20. The method according to any one of claims 14 to 16, wherein a thermal conductivity of the organic compound falls within a range from 0.5 W/mK to 6 W/mK; or
a thermal conductivity of the organic compound falls within a range from 1 W/mK to 3 W/mK.

21. The method according to any one of claims 14 to 16, wherein a Shore hardness of the organic compound is less than or equal to Shore OO 60 after the organic compound is solidified; or
a Shore hardness of the organic compound is less than or equal to Shore OO 30 after the organic compound is solidified.

22. A heat dissipating apparatus, comprising:

a heat dissipating component; and
the thermal pad disposed between the heat dissipating component and a heat emitting component according to any one of claims 1 to 13, or the thermal pad manufactured according to the method specified in any one of claims 14 to 21.

23. An electronic device, comprising:

a heat emitting component;
a heat dissipating component; and
the thermal pad disposed between the heat emitting component and the heat dissipating component according to any one of claims 1 to 13, or the thermal pad manufactured according to the method specified in any one of claims 14 to 21.

100

110

z

y

x

120

FIG. 1

300

| Provide a thermally conductive sheet-like substrate, where the sheet-like substrate has a compressible porous mesh structure in a thickness direction | S310 |

| Provide a thermally conductive and flexible organic compound | S320 |

| Use the organic compound to fill inside the sheet-like substrate and/or coat on a surface of the sheet-like substrate to form the thermal pad | S330 |

FIG. 2

330

| Wind or overlay the sheet-like substrate to form a multilayer sheet-like substrate that has a multilayer structure | S331 |

↓

| Use the organic compound to fill inside the multilayer sheet-like substrate and/or coat on a surface of the multilayer sheet-like substrate to form a first thermal pad blank | S332 |

↓

| Cut the first thermal pad blank along a heat conduction direction of the first thermal pad blank to form the thermal pad | S333 |

FIG. 3

330

| Use the organic compound to fill inside the sheet-like substrate and/or coat on a surface of the sheet-like substrate to form a second thermal pad blank | S334 |

↓

| Wind or overlay the second thermal pad blank to form a third thermal pad blank having a multilayer structure | S335 |

↓

| Cut the third thermal pad blank along a heat conduction direction of the third thermal pad blank to form the thermal pad | S336 |

FIG. 4

500

510

530

FIG. 5

700

720

730

710

FIG. 6

# INTERNATIONAL SEARCH REPORT

International application No.

**PCT/CN2013/074619**

## A. CLASSIFICATION OF SUBJECT MATTER

H05K 7/20 (2006.01) i

According to International Patent Classification (IPC) or to both national classification and IPC

## B. FIELDS SEARCHED

Minimum documentation searched (classification system followed by classification symbols)

IPC: H05K, G06F

Documentation searched other than minimum documentation to the extent that such documents are included in the fields searched

Electronic data base consulted during the international search (name of data base and, where practicable, search terms used)

CPRSABS, CNABS, CNKI, VEN: heat dissipation, surface, network, gird; radiator, radiation, coolant, cooler, cooling, heat conduction, heat sink, heat transfer, thermal, Board, plank, shutter, parcel, patch, piece, flake, slice, pad, layer, aperture, hole, finestra, orifice, meshy, netlike, netted, netty, reticular, reticulate, retiform, honeycomb, comb, high, height, thick, thickness, different, difference, distinctness, tolerance, compress, compression, elasticity, flexibility, springiness, chip, die

## C. DOCUMENTS CONSIDERED TO BE RELEVANT

| Category* | Citation of document, with indication, where appropriate, of the relevant passages | Relevant to claim No. |
|---|---|---|
| P, X | CN 102917574 A (HUAWEI TECHNOLOGIES CO., LTD.), 06 February 2013 (06.02.2013), see claims 1-23 | 1-23 |
| Y | CN 102143649 A (SHENZHEN CHINA STAR OPTOELECTRONICS TECHNOLOGY CO., LTD.), 03 August 2011 (03.08.2011), see abstract, description, page 1, paragraph 3 to page 2, paragraph 21, and figures 1-4 | 1-23 |
| Y | DE 1940852 A1 (DUNLOP CO., LTD.), 12 February 1970 (12.02.1970), see description, page 2, paragraph 3 to page 5, paragraph 2, and page 6, paragraph 2, and figure 2 | 1-23 |
| Y | CN 1345467 A1 (NGK INSULATOR, LTD.), 17 April 2002 (17.04.2002), see claims 1-65, and figure 1 | 1-23 |

☐ Further documents are listed in the continuation of Box C.   ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 July 2013 (10.07.2013) | **01 August 2013 (01.08.2013)** |
| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **LIANG, Tao** Telephone No.: (86-10) **62411847** |

Form PCT/ISA/210 (second sheet) (July 2009)

## INTERNATIONAL SEARCH REPORT
### Information on patent family members

International application No.

**PCT/CN2013/074619**

| Patent Documents referred in the Report | Publication Date | Patent Family | Publication Date |
|---|---|---|---|
| CN 102917574 A | 06.02.2013 | None | |
| CN 102143649 A | 03.08.2011 | US 2012222888 A1 | 06.09.2012 |
| | | WO 2012122731 A1 | 20.09.2012 |
| | | CN 102143649 B | 23.01.2013 |
| DE 1940852 A1 | 12.02.1970 | GB 1250912 A | 27.10.1971 |
| CN 1345467 A | 17.04.2002 | CN 1178297 C | 01.12.2004 |
| | | JP 2004221605 A | 05.08.2004 |
| | | EP 1160860 B1 | 27.10.2010 |
| | | KR 522859 B | 24.10.2005 |
| | | WO 0148816 A1 | 05.07.2001 |
| | | KR 460585 B | 09.12.2004 |
| | | JP 2006295224 A | 26.10.2006 |
| | | KR 20020006666 A | 24.01.2002 |
| | | KR 20040053225 A | 23.06.2004 |
| | | US 6933531 B1 | 23.08.2005 |
| | | JP 2001339022 A | 07.12.2001 |
| | | EP 1160860 A1 | 05.12.2001 |

Form PCT/ISA/210 (patent family annex) (July 2009)